Europäisches Patentamt

**European Patent Office**

**Office européen des brevets**

(19)

(11) Publication number : **0 303 712 B1**

# EUROPEAN PATENT SPECIFICATION

(12)

(45) Date of publication of patent specification :
**15.04.92 Bulletin 92/16**

(51) Int. Cl.⁵ : **H01S 3/097**

(21) Application number : **88901930.3**

(22) Date of filing : **19.02.88**

(86) International application number :
**PCT/JP88/00183**

(87) International publication number :
**WO 88/06810 07.09.88 Gazette 88/20**

(54) **DEVICE FOR DETECTING OUTPUT VOLTAGE OF A LASER OSCILLATOR.**

Divisional application 91100898.5 filed on 19/02/88.

(30) Priority : **03.03.87 JP 48410/87**
**03.03.87 JP 48411/87**
**03.03.87 JP 48412/87**

(43) Date of publication of application :
**22.02.89 Bulletin 89/08**

(45) Publication of the grant of the patent :
**15.04.92 Bulletin 92/16**

(84) Designated Contracting States :
**DE FR GB**

(56) References cited :
**JP-A- 5 965 492**

(56) References cited :
**JP-A-53 117 399**
**JP-A-55 160 485**
**JP-A-58 147 185**
**JP-A-60 180 182**
**JP-A-62 165 984**
**JP-A-62 166 580**

(73) Proprietor : **FANUC LTD.**
**3580, Shibokusa Aza-Komanba, Oshino-mura**
**Minamitsuru-gun, Yamanashi 401-05 (JP)**

(72) Inventor : **EGAWA, Akira Fanuc Mansion**
**Harimomi 3-303**
**1205, Sibokusa Oshino-mura**
**Minamitsuru-gun Yamanashi 401-05 (JP)**

(74) Representative : **Brunner, Michael John et al**
**GILL JENNINGS & EVERY 53-64 Chancery Lane**
**London WC2A 1HN (GB)**

## Description

The present invention relates to an output voltage detecting device in a laser oscillator, and more particularly to an output voltage detecting device in a laser oscillator, in which an output voltage can be detected with a circuit of a simple configuration.

A laser tube for use in a gas laser device has an electrical impedance which varies depending upon an interiorly confined gas status, as a consequence, the voltage supplied to the laser tube varies. For example, in a laser oscillator having a current feedback loop with which a current is fed back to the laser tube, the variation in the electrical impedance of the laser tube causes the supply voltage to vary, since the current is being controlled to be constant. If this condition is left as it stands, semiconductor elements, the laser tube or other elements constituting an inverter may be damaged.

In view of the foregoing, it is conventional practice, to detect the voltage applied to the laser tube and when the resultant voltage is above a reference voltage, an alarm is generated. When the detected voltage is above a danger-level voltage, the driving is stopped. In addition, it has been necessary to detect and monitor the output voltage in order to control the output voltage to be constant.

However, when a transformer is used, it is required to have a considerably high voltage insulation resistivity. The transformer is further required to have a high frequency characteristic attendant to the high frequency power supply unit. For such reasons, transformers which are extremely expensive in cost have had to be employed.

A method in which the voltage is divided by capacitors has the problem such that a power supply line led to the laser tube cannot be isolated from the ground connection of a control apparatus, so that noise is liable to be introduced into the control circuit.

An object of the invention is to resolve the foregoing problems and to provide an output voltage detecting device in a laser oscillator, in which an output voltage is detected with a circuit of a simple configuration, and an abnormal voltage can be monitored.

Another object is to provide an output voltage detecting device which is operable at a low voltage and producible inexpensively.

According to the present invention there is provided an output voltage detecting device for a laser oscillator in which a high frequency power voltage is supplied to a laser tube to perform laser oscillation, the device comprising a current detection circuit connected to an input of an inverter which supplies a high frequency voltage, the circuit being characterised by:

a non-linear element to which a reference voltage is connected;

a current transformer for detecting a current flowing in the non-linear element; and

wherein an abnormality of the output voltage is detected from the current flowing in the non-linear element.

The non-linear element has a non-linear point at a voltage slightly higher than a regular voltage of a converter, and a current versus resistance relationship which is changed abruptly when the voltage applied thereto exceeds the non-linear point voltage. Accordingly, when the output voltage of the converter exceeds the reference voltage, a current flows abruptly in the non-linear element. Thus, upon detection of the current by means of the current transformer, an abnormal voltage is detected.

Details of other aspects of the invention will become apparent when read in conjunction with the later described embodiments and the accompanying drawings, in which:-.

FIG. 1 is block diagram showing first embodiment of the present invention; and

FIG. 2 is a diagram showing a relationship between a voltage and a current of a varistor B.

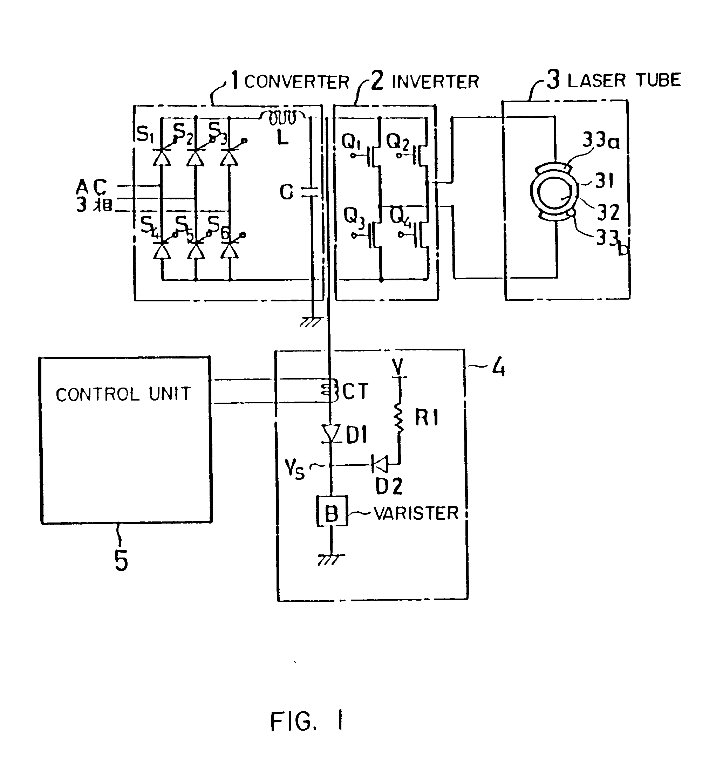

FIG. 1 shows a converter 1 which converts a current from a commercial AC power supply to a DC current by rectification. The converter is comprised of six SCRs $S_1$ through $S_6$.

An inverter 2, which is in the form of a bridge circuit composed of four FETs $Q_1$ to $Q_4$, modulates the DC output voltage from the converter 1 to a high frequency voltage at several megahertz.

A laser tube 3 includes a tube 31 formed, for example, with a silica glass, in the interior of which a laser medium gas 32 is circulated, and electrodes 33a and 33b which apply the high frequency voltage to the tube 31. A discharge takes place by applying a high frequency voltage to the laser medium gas 32 confined within the tube 31, whereby the laser light is oscillated and amplified. The direction in which the laser light is emitted is perpendicular to the surface of the sheet of the drawing.

A current detection circuit 4 is connected to the output of the converter 1. The line extending from the converter 1 is coupled to a current transformer CT then connected to a diode D1. The diode D1 is connected to a varistor B which is a non-linear element. The opposite terminal of the varistor B is connected to ground. The varistor is further connected to a diode D2, and the anode of the diode D2 is connected through a resistor R1 to a reference voltage V.

The reference voltage V is set to be 5 to 10 % higher than the normal voltage of the converter 1. The varistor B as used has a non-linear point, i.e. a point at which a resistance characteristic varies, higher by 10 volts or so than the reference voltage. Accordingly, the voltage $V_S$ depicted in the figure is lower than the non-linear point of the varistor B when the output voltage of the converter 1 is normal, in which case a current little flows in the diode D1.

However, as the voltage of the converter 1 increases and when it exceeds the non-linear point of the varistor B, a current flows abruptly in the diode D1. The current flowing therein is detected by the current transformer CT.

A control unit 5 detects an abnormal voltage responsive to a rising edge of the current flowing in the current transformer CT, whereupon an alarm is generated. When the detected voltage exceeds a danger-level voltage, the gate signals of the thyristors (SCR's $Q_1$ to $Q_6$) in the converter 1 are switched off to thereby stop the converter driving.

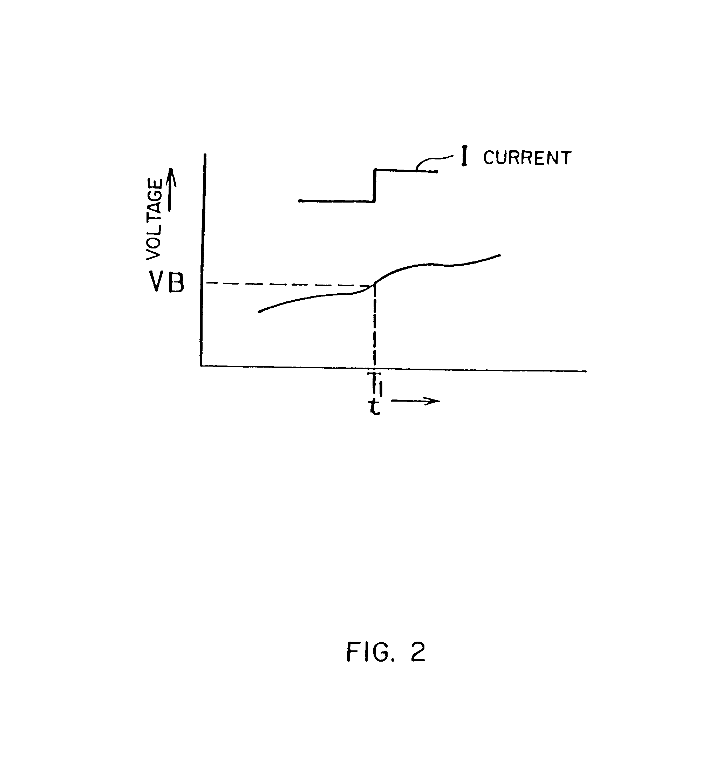

In FIG. 2, there is depicted the relationship between the output voltage and the current of the converter 1. In the figure, the ordinate represents the voltage $V_S$ in FIG. 1 and the abscissa represents time. When the voltage $V_S$ varies as illustrated in the figure and when it exceeds the non-linear point VB of the varistor B at the time instant T1, a current I is abruptly caused to flow in the varistor B. The current flowing therein can be detected by the current transformer CT.

The abnormal voltage can thus be detected with a circuit of simple configuration and the semi-conductor elements, including FET's in the inverter 2 can be protected. Further, since the ground-connected terminals of the converter 1 and the inverter 2 are not connected to the current transformer CT, there is little possiblity oif noise being introduced into the control unit 5.

In the foregoing description a varistor has been exemplified as the non-linear element, but other kinds of non-linear elements, such as a Zener diode operable at high voltage, could also be employed.

A divisional application 91100898.5 has been filed which describes and claims an output voltage detecting device for a laser oscillator in which a booster transformer is provided between a high frequency power supply unit and a laser tube, the device comprising a current transformer coupled in use to a ground terminal of a primary winding of the booster transformer for detecting a current flowing therein; and means for detecting an output voltage of the high frequency power supply unit from a current flowing in the current transformer.

## Claims

1. An output voltage detecting device for a laser oscillator in which a high frequency power voltage is supplied to a laser tube (3) to perform laser oscillation, the device comprising a current detection circuit (4) connected to an input of an inverter (2) which supplies a high frequency voltage, the circuit being characterised by:

a non-linear element (B) to which a reference voltage (V) is connected;

a current transformer (CT) for detecting a current flowing in the non-linear element; and

wherein an abnormality of the output voltage is detected from the current flowing in the non-linear element.

2. A device according to claim 1, wherein the non-linear element is a varistor (B).

3. A device according to claim 1 or claim 2, wherein

the input to the current detection circuit (4) is provided through a first diode (D1);

the reference voltage (V) is applied to the non-linear element through a diode (D2); and,

the current transformer (CT) is arranged to detect the current flowing to the input through the first diode (D1).

## Patentansprüche

1. Anordnung zum Nachweis einer Ausgangsspannung für einen Laser-Oszillator, in dem eine Hochfrequenznetzspannung einer Laserröhre (3) zugeführt wird zur Durchführung der Laseroszillation, wobei die Anordnung einen Nachweisstromkreis (4) aufweist, der mit dem Eingang eines Umformers (2) verbunden ist, der Umformer eine Hochfrequenzspannung liefert und der Stromkreis gekennzeichnet ist durch:

ein nicht-lineares Glied (B), das mit einer Referenzspannung (V) verbunden ist;

einen Stromtransformator (CT) zum Nachweis eines in dem nicht-linearen Glied fließenden Stroms; und

wobei eine Abweichung der Ausgangsspannung von dem in dem nicht-linearen Glied fließenden Strom nachgewiesen wird.

2. Anordnung nach Anspruch 1, wobei das nichtlineare Glied ein Varistor (B) ist.

3. Anordnung nach Anspruch 1 oder 2, wobei

der Eingang zu dem Nachweisstromkreis (4) durch eine erste Diode (D1) geschaffen ist;

die Referenzspannung (V) durch eine Diode (D2) dem nicht-linearen Glied zugeführt wird; und

der Stromtransformator (CT) zum Nachweis des Stromes, der durch die erste Diode (D1) dem Eingang zufließt, vorgesehen ist.

## Revendications

1. Dispositif détecteur de tension de sortie d'un oscillateur de laser suivant lequel une tension de haute fréquence est amenée à un tube de laser (3) pour assurer l'oscillation du laser, le dispositif prévoyant un circuit détecteur de courant (4) raccordé à l'entrée d'un inverseur (2) apportant la tension de haute fréquence, ledit circuit étant caractérisé par:

un élément non-linéaire (B) auquel est raccordé une tension de référence (V);

un transformateur de courant (CT) de détection du courant passant par l'élément non-linéaire; et

dont une anormalité de tension de sortie est détectée à partir du courant passant par l'élément non-linéaire.

2. Dispositif suivant la revendication 1, dont l'élément non-linéaire est un varistor (B).

3. Dispositif suivant la revendication 1 ou 2, dont l'amenée au circuit de détection de courant (4) est assurée par l'intermédiaire d'un varistor (B);

la tension de référence (V) est appliquée à l'élément non-linéaire par l'intermédiaire d'une diode (D2); et,

le transformateur de courant (CT) est agencé de manière à détecter le courant passant par la première diode (D1) vers l'entrée.

## 1 CONVERTER    2 INVERTER    3 LASER TUBE

S₁ S₂ S₃

L

Q₁ Q₂

33a

31

AC

3 φ

C

32

S₄ S₅ S₆

Q₃ Q₄

33b

CONTROL UNIT

CT

V

R₁

~4

D1

Vₛ ~

D2

B — VARISTER

5

FIG. 1

FIG. 2